# EUROPEAN PATENT SPECIFICATION

(11) **EP 2 716 146 B1**
(45) Date of publication and mention of the grant of the patent: **19.04.2017**
(21) Application number: 11866867.2
(22) Date of filing: 01.06.2011
(51) Int. Cl.: H05K 7/20, F28F 13/06, F28F 17/00

(54) **COOLING OF ELECTRONIC COMPONENTS IN AN ENCLOSURE**
KÜHLUNG VON ELEKTRONISCHEN BAUELEMENTEN IN EINEM GEHÄUSE
REFROIDISSEMENT DE COMPOSANTS ÉLECTRONIQUES DANS UNE ENCEINTE

(43) Date of publication of application: 09.04.2014
(73) Proprietor: Telefonaktiebolaget LM Ericsson (publ), 164 83 Stockholm (SE)
(72) Inventor: ÅBERG, Göran, S-118 42 Stockholm (SE)
(74) Representative: Ericsson
(86) International application number: PCT/SE2011/050691
(87) International publication number: WO 2012/166031

(56) References cited:
- EP-A1- 0 485 281
- WO-A1-2009/020664
- GB-A- 2 404 977
- US-A1- 2008 291 626
- US-A1- 2009 120 622
- US-A1- 2010 263 830
- US-B1- 6 819 563
- US-B1- 6 896 612

## Description

### TECHNICAL FIELD

The present invention relates generally to achieving reliable working conditions for heat generating equipment. In particular, the present invention relates to transferring surplus heat away from heat generating equipment arranged in an enclosure.

### BACKGROUND

As information technology emerges, networking components handles traffic more efficiently, but the traffic per network node increases even more. This results in that the new network nodes require more power and that the total power consumption per node increases. Network components are commonly arranged in cabinets or racks. To get good MTBF (Mean-Time Between Failure) on the nodes in a cabinet the air in the cabinet must be kept cool and any heat generated must be efficiently vented out.

Today, there exists some methods for cooling electronic components, e.g. active cabinet cooling solutions which ventilate heat away from the electronic components by fans, or supplies pre-cooled air to the electronic components. However, such methods require a lot of energy for cooling down the air to be supplied, or driving the fans to keep the cabinet cool. Using fans will, apart from power consumption, add cost, complexity, failure rate, volume and noise to the cabinet.

Further known solutions include arranging a heat exchanger near the air outlet of the cabinet in order to cool down the air leaving the cabinet and transfer the heat away from the room in which the cabinet resides, see e.g. US Patent No 7,051,802 (B2). However, in practice this solution also require one or more additional fans to be arranged in combination with the heat exchanger in order to produce a sufficient air flow through the heat exchanger for achieving a desirable cooling function.

Document US 6 819 563 B1 discloses an air cooling of electronics systems using a cooling fluid to cool air entering the electronics system, and to remove a portion of the heat dissipated by the electronics. A cooled electronics system includes a frame, electronics drawers, fans or air moving devices, and an inlet heat exchanger. A cooling fluid such as chilled water is supplied to the inlet heat exchanger, to cool incoming air below ambient temperature. Fans cause ambient air to enter the system, flow through the inlet heat exchanger, through electronic devices, and exit the system. Heat exchangers are pivotally mounted, providing drawer access. Segmented heat exchangers provide access to individual drawers. Airflow guides such as louvers are provided at inlets and outlets.

In view of the prior art, there is a need for a solution for transferring surplus heat away from electronic components that obviates, or at least reduces, the need for additional fans.

### SUMMARY

It is an object of the invention to address at least some of the problems outlined above. In particular, it is an object to achieve a relatively simple and energy-efficient transferring of surplus heat away from electronic components.

Therefore, a cooling unit for cooling air according to the present invention is provided. The cooling unit is arranged for connection to an enclosure comprising heat generating equipment so that air to be cooled can be induced into the cooling unit. The cooling unit comprises a plurality of heat exchangers arranged in parallel to each other. The heat exchangers are further provided with air guides arranged between adjacent heat exchangers for guiding the air through the heat exchangers. The heat exchangers are arranged to absorb heat from the air passing through the heat exchangers and to expel the absorbed heat from the enclosure.

An advantage with such an cooling unit is that the hot air in connection with the enclosure can be cooled by enabling a relatively small pressure drop over the heat exchangers. A decreasing pressure drop results in higher air velocities through the heat exchangers which in turn reduces the need for additional fans. According to a further embodiment of the invention an enclosure comprising heat generating equipment is provided. The enclosure comprises one or more air inlets for inducing air into the enclosure, the air absorbing heat from the heat generating equipment. The enclosure further comprises one or more air outlets for expelling air from the enclosure and a plurality of heat exchangers arranged in parallel to each other and arranged in connection with at least one of the air outlet(s) and/or air inlet(s). The heat exchangers are arranged such that the air flows in between the heat exchangers and is guided through the heat exchangers by air guides arranged between adjacent heat exchangers, the heat exchangers being arranged to absorb heat from the air and expel the absorbed heat from the enclosure.

An advantage with such an enclosure is that air velocities through the heat exchangers will be relatively high, thereby reducing the need for providing the enclosure with additional fans.

### BRIEF DESCRIPTION OF THE DRAWINGS

Reference will now be made, by way of example, to the accompanying drawings, in which:
Figure 1 shows a perspective view of an enclosure provided with a cooling unit on top of the enclosure according to an embodiment of the invention;
Figure 2 schematically illustrates a cross section of a conventional cooling unit;
Figures 3-5 schematically illustrate alternative solutions of the present invention, including different mechanisms for adjusting the air flow through the heat exchangers;
Figure 6 schematically illustrates a cooling unit comprising drop plates according to an embodiment of the invention;
Figure 7 schematically illustrates a cross section of an enclosure with a cooling unit arranged within the enclosure according to an embodiment of the invention;
Figure 8 schematically illustrates a cross section of an enclosure with a cooling unit arranged on top of the enclosure according to an embodiment of the invention;
Figures 9-10 schematically illustrates cross sections of enclosures with cooling units arranged on the backside of the enclosures according to embodiments of the invention; and
Figures 11-12 schematically illustrates cross sections of enclosure assemblies with cooling units arranged on top of the enclosure assemblies according to an embodiment of the invention.

### DETAILED DESCRIPTION

This section gives detailed description about embodiments of the present invention. The following detailed description of the exemplary embodiments refers to the accompanying drawings. The same reference numbers in different drawings identify the same or similar elements. Also, the following detailed description does not limit the invention. Instead, the scope of the invention is defined by the appended claims.

With the term "enclosure" is in this description meant any suitable arrangement of electronic components in e.g. a rack, frame, support, or cabinet.

The term "heat generating equipment" is used to define any electronic component, or equipment arranged in an enclosure, and which generates surplus heat, e.g. cards in a base station in a mobile communication network, or computer servers in a server room, etc.

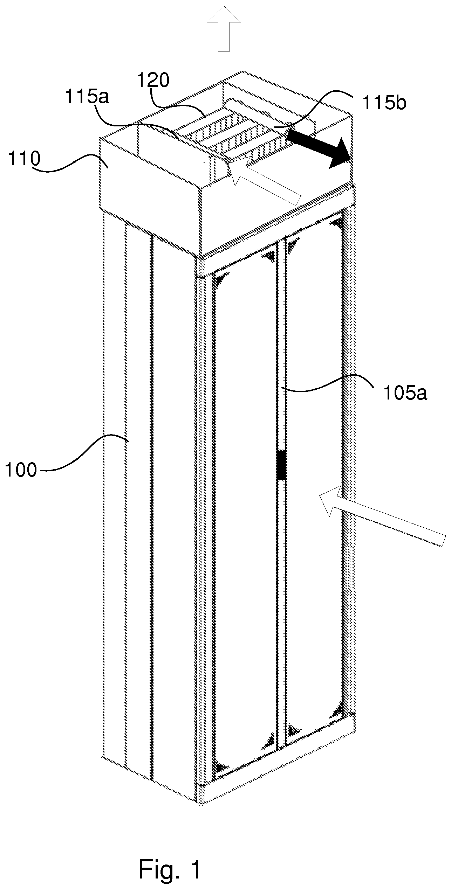

Figure 1 shows a perspective view of an enclosure 100 provided with a cooling unit 110 on top of the enclosure according to an embodiment of the invention. The enclosure comprises heat generating electronic equipments, which are not shown in the figure since the enclosure is provided with doors. Ambient air enters the enclosure via an air inlet 105a (the incoming air is indicated by the arrow next to the air inlet 105a). Internal fans in the enclosure are used to induce the air into the enclosure and to distribute the air over the electronic equipment. The cold air absorbs heat from the electronic equipment and the thus heated air is expelled from the enclosure through an air outlet. The air outlet is not shown in the figure, but is in this example provided at the top side of the enclosure directly below the cooling unit. Accordingly, adjacent to, and directly above, the air outlet is the cooling unit arranged whereby the air is induced through the under side of the cooling unit. Within the cooling unit the air is guided through heat exchangers 120, where the heat exchangers are arranged in a substantially vertical manner. As the air passes the heat exchangers the air is cooled whereby the cooled air is expelled into the surroundings of the enclosure (air cooled by the cooling unit is indicated by the arrow above the enclosure). The incoming air is approximately heated from 25°C to 30-60°C by the electronic equipment within the enclosure.

Preferably the air is cooled to correspond with the ambient air temperature of approximately 25°C after passage through the cooling unit.

The cooling unit and its heat exchangers are supplied with a cooling medium entering one or more inlet pipes 115a. An inlet pipe being e.g. a substantially horizontally arranged pipe from which the vertically arranged heat exchangers receive their cooling medium. The cooling medium heated by the air passing through the heat exchangers exits the cooling unit via one or more outlet pipes 115b. The heat absorbed by the heat exchangers is thus removed from the vicinity of the enclosure. Preferably the heat is removed from the room in which the enclosure reside, thereby the heat generated by the electronic equipment has no impact on the enclosure's ambient temperature and the incoming and outgoing air will have approximately the same temperature. The impact on the room's air conditioning facilities will thus be minimized.

The incoming cooling medium is indicated by the empty arrow directed towards the inlet pipe 115a and the outgoing cooling medium is indicated by the filled arrow directed away from the outlet pipe 115b. Circulation of the cooling medium can be accomplished using a pump, or some form of self-circulation, such as a thermosiphon or heat pipe.

The cooling medium is preferably water but it can e.g. also be a two-phase refrigerant which may pose a better heat transfer capacity. A two-phase refrigerant would also reduce the risk of leakage from the cooling unit since the refrigerant will evaporate at atmospheric pressure.

The air inlet 105a is in this example in the form of an opening in the front side of the enclosure, but the inlet could also be arranged at any other side of the enclosure including the bottom. Different designs of the air inlet are known, but it is preferably in the form of a plurality of minor openings provided with filters such that dust and dirt are prevented from entering the enclosure. The air outlet may have a similar design with or without filters.

The temperature of the cold air can e.g. be approximately the same as the air temperature in the rest of the room in which the enclosure resides. It could of course also differ and e.g. be pre cooled using a cooling aggregate or similar.

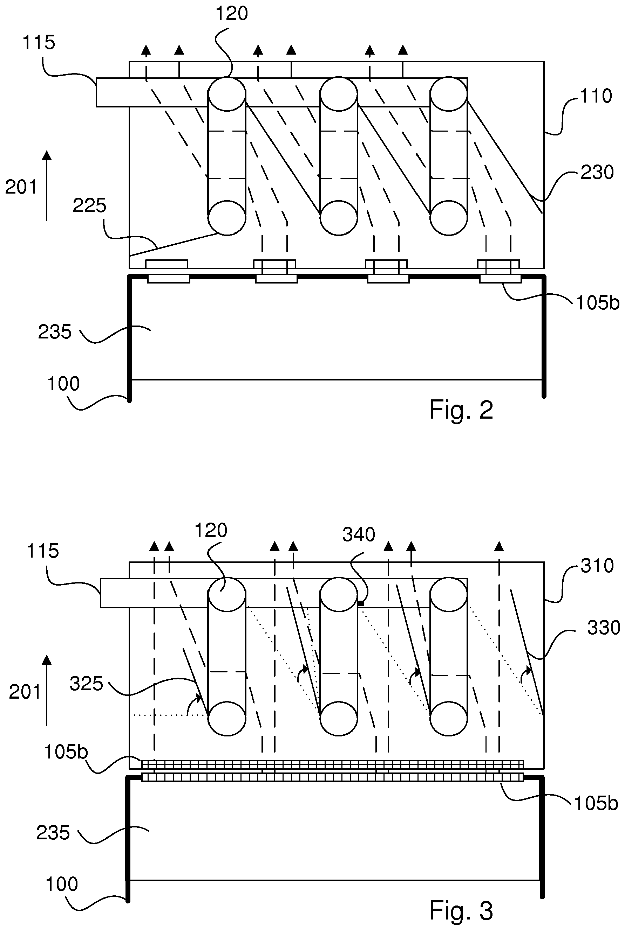

Figure 2 schematically illustrates a cross section of a conventional cooling unit 110. Heated air (air flow is indicated by the broken lines) arises from electronic equipment 235 and exits the enclosure 100 through a plurality of air outlets 105b. It should however be mentioned that the air outlet may be a single, large outlet (see e.g. Fig. 3). The heated air enters the cooling unit through openings arranged in the bottom of the cooling unit. The air is then guided through substantially vertically arranged heat exchangers 120 via air guides 230 that connect adjacent heat exchangers. An air guide 230 is preferably arranged between a lower part of one heat exchanger to an upper part of an adjacent heat exchanger. Air passing between any two heat exchangers will then, in this example, pass through the left of the two heat exchangers, where after cooled air will exit the cooling unit. The heat exchangers are arranged in parallel to each other and approximately equidistant from each other. Thereby each heat exchanger cools substantially the same amount of heated air. Since the heated air enters the heat exchangers from below and is guided towards the heat exchangers by the air guides, the entire height of the heat exchangers will be used for cooling, thus increasing the cooling efficiency. In the lower part of the leftmost heat exchanger a further air guide (stop guide) 225 is arranged, being connected to the inner wall of the cooling unit. The function of the air guide 225 is mainly to prevent the heated air from bypassing the cooling unit, but it can also function to guide heated air in between two heat exchangers 120 by arranging it in an inclined position as in Figure 2. Cooling medium is provided to the heat exchangers via the pipe 115 and cooling medium heated by the air is expelled from the vicinity of the enclosure via similar pipes. The heat exchangers being arranged in a substantially vertical manner means that they extend with an angle of between 75 - 105 degrees from a horizontal plane or the plane of the side where the air outlet is arranged. The heat exchangers have thus a substantially vertical extension direction 201. By arranging the heat exchangers vertically, the pressure drop over the cooling unit will be small and thus the air velocity through the heat exchangers will be high. The air passage through the heat exchangers will accordingly be kept at a high level, whereby the cooling unit will be efficient and thus reducing the need for additional fans.

Throughout this application, the term "heat exchanger" is used for describing an element that cools the heated air. Each heat exchanger can be seen as a vertically arranged heat exchanging element connected to an inlet and an outlet for supply and expel, respectively, of the cooling medium. The cooling medium passes through cooling tubes within the heat exchanger, the cooling tubes being in thermal contact with cooling fins and when the air passes these cooling fins the air temperature is decreased.

In embodiments of the invention the heat exchangers have a thickness of between 3-5 centimetres, a width of 40-45 centimetres and a height of 30-35 centimetres. The area of each heat exchanger that is subjected to the air flow is thus approximately (30-35) * (40-45) = 1200 - 1575 cm². The dimensions may divert from the above mentioned, especially the height can be higher if there is room. In Figure 2 the number of heat exchangers within a cooling unit is three, but the invention is of course not limited thereto - two, four or more heat exchanger can also achieve advantages of the invention. Preferably the cooling unit 110 is approximately 19 inches wide and 19 inches deep, so that it can be easily arranged on top or within a standard telecommunication cabinet. The heat exchangers can be freely oriented in the horizontal plane and e.g. extend from the front to the back or from the left side to the right side, with reference to the enclosure.

The cooling unit can be connected to an enclosure using any suitable fastening means, e.g. screws and bolts, pins, straps, rails, etc.

Figure 3 schematically illustrate the present invention where the air flow through the heat exchangers can be adjusted by pivoting the air guides of the cooling unit 310. The air guides 330 are arranged such that at least parts of the heated air can bypass the heat exchangers. As indicated by the broken lines, part of the air bypasses the heat exchangers whereas part of the air passes through the heat exchangers. As can be seen the stop guide 325 is in this embodiment also pivotable. In order to achieve the pivoting, some form of hinge or swivel means should be provided on the air guide or at the connection between the heat exchanger and the lower part of the air guide.

The position of the air guides 325, 330 is dependent on one or more conditions within the enclosure. An example of such a condition is when the pressure within the enclosure exceeds a certain limit, e.g. 50 Pa, whereby the force resulting from the internal pressure within the enclosure exceeds the gravitational force of the air guides and the air guides open. When the pressure decreases the air guides slowly return to their initial position connecting adjacent heat exchangers. The pressure at which air guides are set to pivot can be modified by having air guides of different material, e.g. metal or plastic, and/or thickness. Another option would be to insert a stop block 340, whereby the air guide is set to open when the pressure force exceeds the gravitational force of the air guide plus the downright force from the stop block. The gravitational force of the air guide will then be smaller than the pressure force, but when the pressure force exceeds the force from the stop block and the gravitational force the air guide will open more fully. This requires however that the stop block is so arranged that it is easier for the air guide to return to its initial, closed state than it is to transfer from closed to open state.

Many enclosures comprising electronic equipment use speed controlled integral cooling fans. Most often the fan speed is low and this is also when it is important to cool down the exhaust air. When the fan speed is low everything is normally under control and the air guides will be in their initial position. When the fan speed is high, on the other hand, something is wrong and it would normally be OK to bypass (at least partly) the heat exchangers. This function may be very important since the air flow resistance is sensitive to air velocity/speed. Effect of a fan is dependent on the velocity to the power of 3 (V x V x V). This means that if the velocity is doubled the effect have to be 16 times higher. By bypassing the air flow, an increase in velocity can be managed by a lower fan power. Thereby the integral cooling fans within the enclosure have a higher probability of providing a sufficient air flow when a high velocity/speed is required.

When the air bypasses the heat exchangers the ambient temperature will of course be affected. However, the temperature in the enclosure should normally return to more ordinary temperatures quite soon or otherwise some maintenance of the equipment within the enclosure may be required. During this period the cooling effect may be reduced, however it may be of higher priority to make sure that the electronic equipment receives sufficient air flow. Further, the reason for the increased fan speed may be that the supply of cooling medium have been interrupted and caused an increase in temperature. In such a situation there would be no use in forcing the air through the heat exchangers.

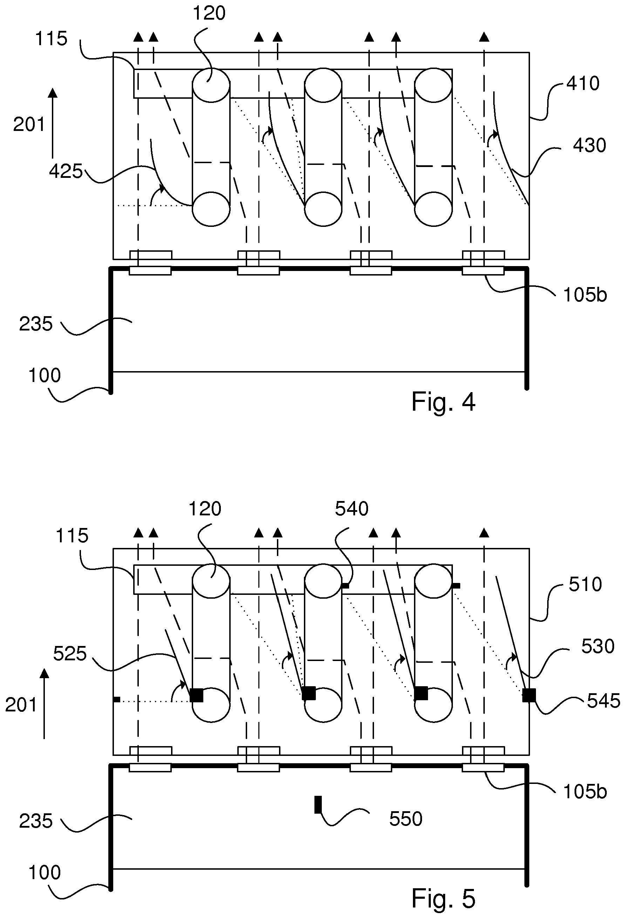

Figure 4 schematically illustrate an alternative of the present invention where the air flow through the heat exchangers can be adjusted by pivoting the air guides of the cooling unit 410. This alternative practically functions in the same way as the alternative described with reference to Figure 3. The difference being that the air guides 425, 430 bends depending on the force coming from the air pressure and the air flow, instead of pivots. No hinge or swivel means is thus provided and the air guides should be made of a material, e.g. thin metal that is not easily deformed or some form of plastic, having lower bending strength or being thinner compared to e.g. the air guides used in Figure 3. Figure 5 schematically illustrate an alternative of the present invention where the air guides 525, 530 of the cooling unit 510 can be electronically adjusted using controlling units 545. The controlling units are being communicatively connected (with wires or wireless) to one or more sensors 550 arranged within the enclosure 100. The sensors are provided in order to sense one or more conditions within the enclosure, e.g. speed (rpm) of component fans, temperature and/or pressure. In case that the sensors detect a condition anomaly, this can trigger a controlling unit 545 to change the state of an air guide 530. The change of state can be triggered by an isolated condition, such as high temperature, or a combination of many conditions, such as high temperature and high fan speed.

The state of the air guides can be changed in different ways. They can e.g. be pivoted as described in the embodiment with reference to Figure 3, the difference being that in the embodiment shown in Figure 5 the air guides are pivoted by using an electrically controlled controlling unit 545.

As an alternative, or as a complement, a stop block 540 solution can be used. Normally the stop block will prevent an air guide from opening, but upon detection of a condition, the position of the stop block can be amended, e.g. the stop block can be pulled in so that the air guide can open. This alternative may include that the air guide is made of a lightweight material so that it will open by forces from within the enclosure upon retraction of the stop block.

A further alternative include electric wires arranged in the air guides which will cause the air guides to bend when subjected to currents in the wires - the magnitude of the currents being dependent on the sensed conditions. A still further alternative include rolling means, whereby the air guide is rolled in, also depending on the sensed conditions, in the same way as an awning.

Some or all of the air guides can be set to open depending on one or more conditions within the enclosure. Further, instead of changing an entire air guide's position, parts of the air guide can be set to open or change its position depending on the conditions. Still further, some air guides (or parts of air guides) can be dependent on certain conditions, e.g. temperature, whereas other air guides (or parts of air guides) can be dependent on other conditions e.g. fan speed.

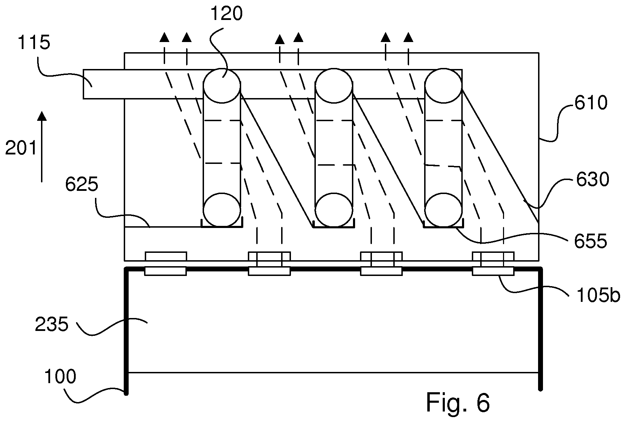

Figure 6 schematically illustrates a cooling unit 610 comprising drop plates 655 according to an embodiment of the invention. The drop plates are arranged below the heat exchangers for collecting condense liquid formed on the heat exchangers or liquid leaking from the heat exchangers. The drop plates are preferably connected to a drain pipe or a collector so that the liquid is removed from the cooling unit. The use of drop plates assure that the heat exchangers can be placed above electronic equipment and reduce the risk that condense liquid leakage reaches the electronics.

The drop plates may be connected to the heat exchangers using some form of fastening means such as welding, screws, nails, etc. The drop plates can also be separate from the heat exchangers but connected and fastened to the walls of the cooling unit. The drop plates can be integrated with the air guides but can also be separate from the drop plates.

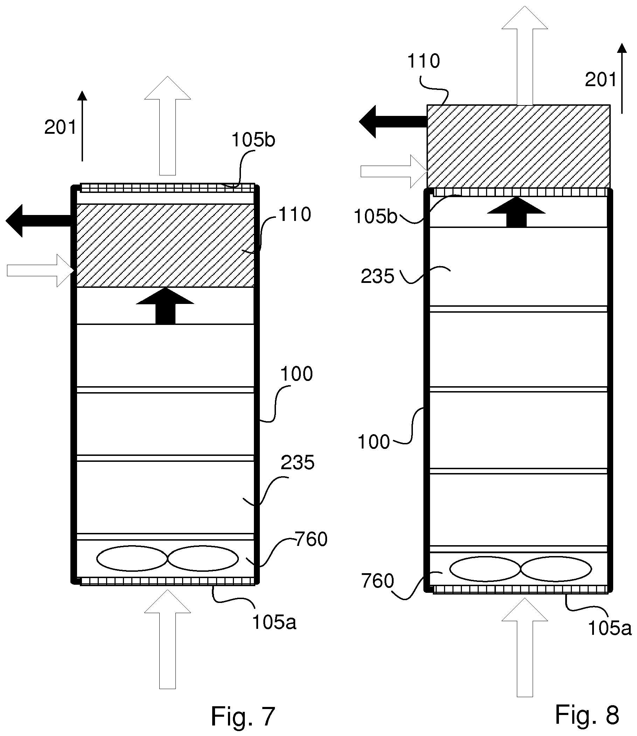

Figure 7 schematically illustrates a cross section of an enclosure with a cooling unit 110 arranged within the enclosure 100 according to an embodiment of the invention. The enclosure comprises heat generating electronic equipment 235, arranged in separated mounting racks. Cold air (see empty arrow at the bottom of the figure) enters the enclosure via an air inlet 105a, in this embodiment provided at the lower part (bottom) of the enclosure. Internal cooling fans 760 are used to induce the air into the enclosure and to distribute the air over the electronic equipment, whereby the air is heated. The heated air (see filled arrow within the enclosure) enters the cooling unit 110 provided at the top of the inside of the enclosure. The heated air is cooled by the heat exchangers in the cooling unit and cold air (see empty arrow at the top of the figure) is expelled from the enclosure through an air outlet 105b provided close to, and above, the cooling unit. Cooling medium provided to the heat exchangers is indicated by the empty arrow to the left of the cooling unit and cooling medium heated by the air being expelled from the vicinity of the enclosure is indicated by the filled arrow also to the left.

Connecting the cooling unit to the inside of the enclosure assures that the cooling unit does not interfere with overhead cabling and also that the enclosure takes up a smaller volume. This may be desired when the ceiling height is low or when enclosure with cooling functionality shall be delivered in one piece.

Figure 8 schematically illustrates a cross section of an enclosure 100 with a cooling unit 110 arranged on top of the enclosure according to an embodiment of the invention. This embodiment practically functions in the same way as the embodiment described with reference to Figure 7. One difference being that the air heated by the electronic equipment passes the air outlet 105b before entering the cooling unit 110. This makes no major difference since in both embodiments the hot air is cooled as close as possible to the equipments air exhaust (air outlet 105b). Providing the cooling unit in direct proximity to the air outlet makes it highly efficient due to the large temperature differences that are present. Arranging the cooling unit on top of the enclosure has the advantage that more space is available for electronic equipment within the enclosure.

Alternatively, a plurality of cooling units can be arranged within the enclosure, if further cooling functionality is required or desired.

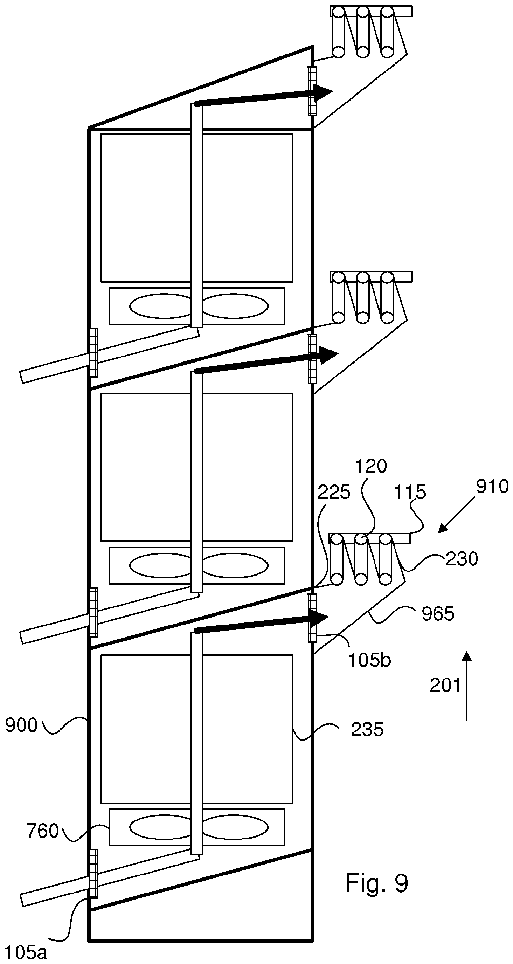

Figure 9 schematically illustrates a cross section of an enclosure 900 with cooling units 910 arranged on the backside of the enclosure according to an embodiment of the invention. Cold air enters the front side of the enclosure through air inlet 105a. A fan 760 arranged below heat generating electronic equipment 235 distributes the air which is accordingly heated by the electronic equipment and exhausted through air outlet 105b provided at the back of the enclosure. The heated air is then guided by air guides 225, 965 in between the vertically arranged heat exchangers 120 from the underside of the heat exchangers. Further air guides 230 leads the air through the heat exchangers whereby the heated air is cooled.

As can be seen in the figure a plurality of cooling units may be connected to the enclosure. In this example three cooling units are provided, each being in direct connection with the backside such that air outlet of the enclosure is arranged directly below the cooling units. Each mounting rack with electronic equipment is thus provided with a cooling unit. An advantage with arranging the cooling units at the backside is that the risk of leakage from the cooling medium onto the electronic equipment is further reduced, since the electronic equipment is not arranged directly beneath the cooling units.

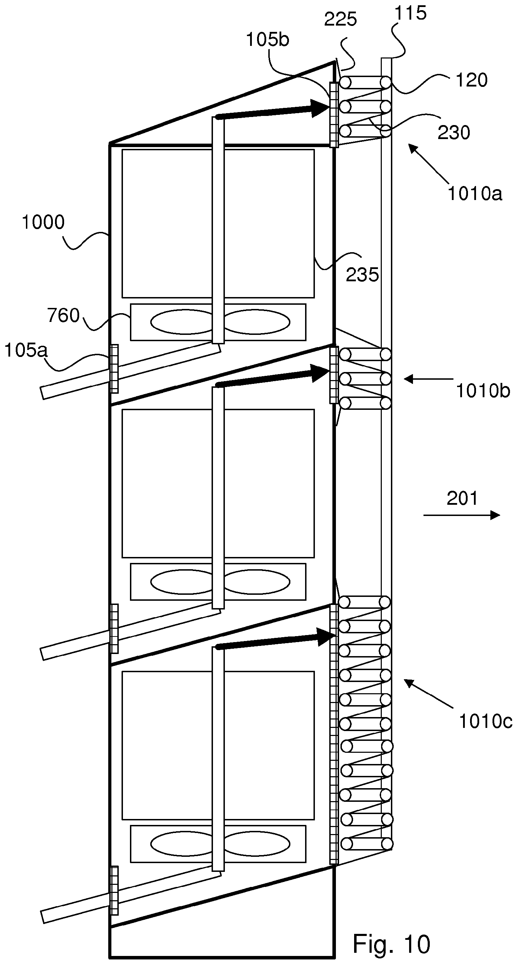

Figure 10 schematically illustrates a cross section of an enclosure 900 with cooling units 1010a, 1010b, 1010c arranged on the backside of the enclosure according to an embodiment of the invention. Cold air enters the front side of the enclosure through air inlet 105a. A fan 760 arranged below heat generating electronic equipment 235 distributes the air which is accordingly heated by the electronic equipment and exhausted through air outlet 105b provided at the back of the enclosure. The heated air then flows in between horizontally arranged heat exchangers 120 from the left side of the heat exchangers. Air guides 230 leads the air through the heat exchangers whereby the heated air is cooled.

In difference to the previously described embodiments the heat exchangers in this embodiment is arranged in a substantially horizontal manner, with a horizontal extension direction 201. However, the heat exchangers are still arranged in a substantially orthogonal manner in relation to the air outlet and to the side/plane where the air outlet is arranged. Of interest is that the air flows in between the heat exchangers and that the air flow has substantially the same flow direction as the extension direction of the heat exchangers when entering the left side of the heat exchangers. Thereby the flow through the heat exchangers will be efficient. The heat exchangers being arranged in a substantially orthogonal manner means that they extend with an angle of between 75 - 105 degrees from the plane of the side where the air outlet is arranged. This arrangement of the heat exchangers will result in a small pressure drop over the heat exchangers and thus the air velocity through the heat exchangers will be high. The air passage through the heat exchangers will accordingly be kept at a high level, whereby the cooling unit will be efficient and thus reducing the need for additional fans.

As seen in Figure 10, an air guide 230 may be arranged to extend from the side of the heat exchanger that is closest to the air outlet to the far side of the adjacent upper heat exchanger, see cooling unit 1010a. The bypassing function would herewith preferably be performed by use of a controlling unit, bending of the air guide or use of a stop block. An advantage with this way of arranging the air guides is that heated air diverts upwards, so the air guides will not counteract the air flow.

Air guide 230 may further be arranged to extend from the side of the heat exchanger that is closest to the air outlet to the far side of the adjacent lower heat exchanger, see cooling unit 1010b. The bypassing function would herewith preferably be performed by pivoting; but also a controlling unit, bending of the air guide or a stop block may be used.

As can be seen in the figure a plurality of cooling units 1010a-c may be connected to the enclosure. In this example three cooling units are provided, each being in direct connection with the backside and the air outlet of the enclosure. The cooling unit 1010c in the lower part of the enclosure comprise 11 heat exchangers whereas the upper cooling units 1010a-b, only comprise three heat exchangers each. Providing the heat exchangers on the backside of the enclosure makes it possible to have more heat exchangers for cooling the heated air. More heat exchangers lead to a lower pressure drop over each heat exchanger which further increases the air velocity and consequently the cooling efficiency. In this embodiment all heat exchangers are connected to the same cooling medium pipe 115 - this is however not necessary even though it may be advantageous from a construction point of view. In this embodiment the height of the heat exchangers extend horizontally compared to vertically as in the previous embodiments.

As an alternative to having a plurality of cooling units, each heat exchanger could be connected to an adjacent heat exchanger resulting in the entire backside of the enclosure to be connected with heat exchangers. A further alternative would be to rotate the heat exchangers 90 degrees in the back plane, so that the width of the heat exchangers extends from a lower part to the upper part of the enclosure. The width would then extend vertically and the height would extend horizontally, in comparison to the previously described embodiments (with reference to figures 1-9) where the width extends horizontally and the height extends vertically.

It should also be mentioned that the cooling units could, as an alternative or as a complement, be provided in connection with the air inlets in order to cool the air entering the enclosure instead of at the outlets.

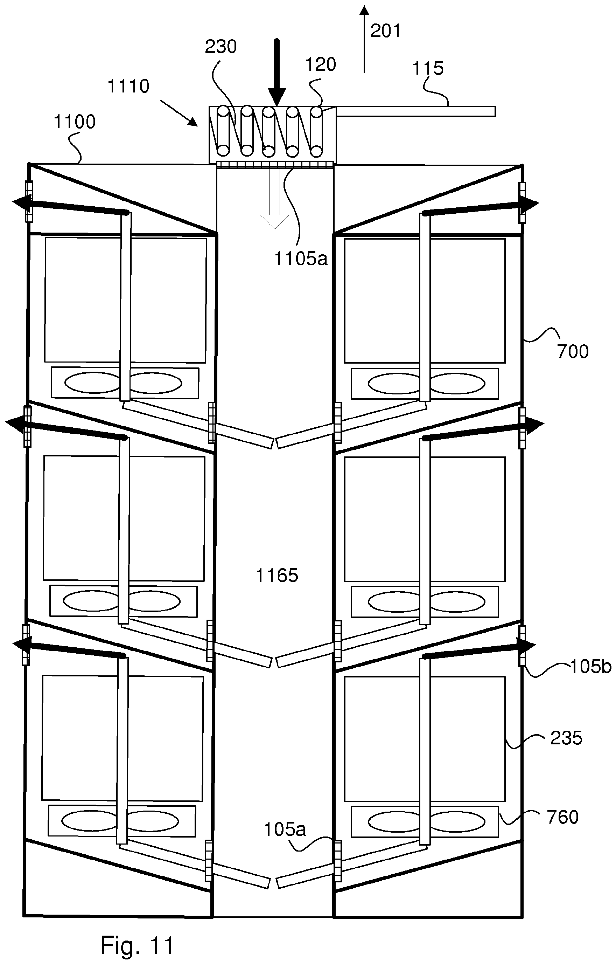

Figure 11 schematically illustrates a cross section of an enclosure assembly 1100 with a cooling unit 1110 arranged on top of the enclosure assembly. The enclosure assembly comprises two or more enclosures 700 arranged a distance apart. The space that separates the enclosures is called an aisle containment 1165. Air entering the cooling unit 1110 is cooled by the heat exchangers 120 such that the air induced into the aisle containment via the air inlet 1105a is cooler than the air outside of the enclosure assembly - this is called cold aisle containment. Air is then induced into the enclosures by their respective air inlets 105a, heated by the heat generating equipment 235 and exhausted to the outside of the enclosure assembly via air outlets 105b. A plurality of enclosures can be arranged side by side making up two rows of enclosures - the more enclosures, the longer aisle containment. Preferably the cooling unit covers the entire top/roof of the aisle containment. The aisle containment is preferably provided with side walls making it a relatively closed space. If the air guides 230 are provided with hinge or swiveling means for bypassing air, these means should preferably be provided on the upper side of each air guide.

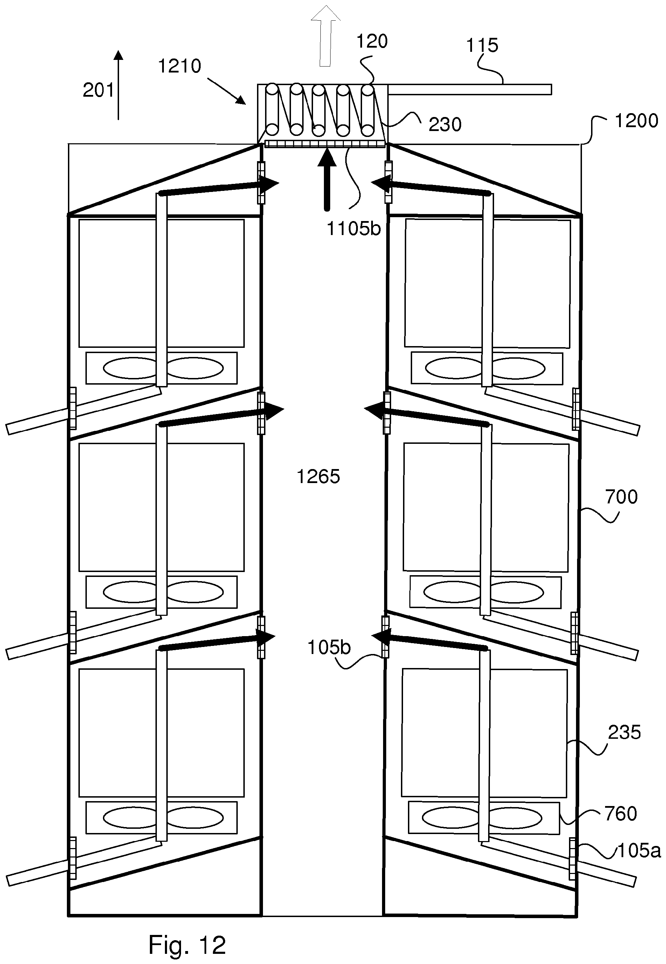

Figure 12 schematically illustrates a cross section of an enclosure assembly 1200 with a cooling unit 1210 arranged on top of the enclosure assembly. Compared to the embodiment described with reference to Figure 11, the air outlets 105b of the enclosures 700 are facing each other and thus the aisle containment 1265. Air entering the enclosures via air inlets 105a is taken from outside of the enclosure assembly, heated by the heat generating equipment 235 and exhausted to the aisle containment, this is called a hot aisle containment. From the aisle containment, the heated air is induced into the cooling unit 1210 via the air outlet 1105b. Air entering the cooling unit 1210 is cooled by the heat exchangers 120 in the same way as in the previous embodiments.

Even though the embodiments described with reference to figures 11 and 12 refer to cooling units connected to an assembly of enclosures, these enclosure assemblies can be seen as an enclosure as described with reference to figures 1 and 7-8.

It should be mentioned that all cooling units 110, 310, 410, 510 and 610 described with reference to figures 2-6 all are compatible with the enclosures described with reference to figures 1 and 7-8. It should also be mentioned that all cooling units 110, 310, 410, 510 and 610 described with reference to figures 2-6 all are compatible with the enclosures described with reference to figures 9 - 12, however some slight modification may have to be made when it comes to the dimensions and the provision of e.g. the air guide 965. Similarly, the cooling units 910, 1010a-c described with reference to figures 9 and 10 are compatible with the enclosures described with reference to figures 1 and 7-8 provided that there is some sort of air outlet arranged at the back of the enclosures.

All enclosures and enclosure assemblies described with reference to figures 1 and 7 -12 supports cabling both from overhead and from below a raised floor.

All alternatives of the present invention make it possible to cool a hot air stream by enabling a small pressure drop at a small "foot-print" (floor area). Small pressure drop can be achieved if the heat exchanger cross section is large. Small pressure drop is in this invention achieved by the use of multiple heat exchangers arranged in parallel where the hot air is set to enter the heat exchangers from a first side and led through the heat exchangers by air guides. For optimum performance the extension direction of the air flow should substantially correspond to the extension direction 201 of the heat exchangers (the height of the heat exchangers) when the air flow enters the first side of the heat exchangers. The "first side" of the heat exchangers is defined as the bottom of the cooling units described with reference to figures 2-9 and 12, and the left of the cooling units described with reference to figure 10, and the upper side of the cooling unit described with reference to figure 11. The pressure drop over the heat exchanger shall be low, otherwise the equipment inside the enclosure will quickly be overheated or additional fans will be needed. Additional fans would increase noise, power consumption and failure rate and shall thus be avoided. The height of the cooling unit and the enclosure shall be as small as possible, which is also facilitated by the exclusion of additional fans.

Under certain circumstances however, it may be desirable to further increase the cooling efficiency. The addition of fans for increasing the air flow through the cooling unit may then be added. However, by using the solution according to the invention described above, it would suffice to use low power fans instead of more power demanding fans as may be required by the prior art. These additional fans should be arranged in close connection to, or within the cooling unit, in order to increase the air flow through the heat exchangers as a complement to the air flow generated by the fans 760 integrated in the enclosure comprising the electronic equipment 235.

## Claims

1. Cooling unit (110, 310, 410, 510, 610, 910, 1010a-c, 1110, 1210) for cooling air, the cooling unit being arranged for connection to an enclosure (100, 900, 1100, 1200) comprising heat generating equipment (235) so that air to be cooled can be induced into the cooling unit, the cooling unit comprising a plurality of heat exchangers (120) arranged in parallel to each other, the heat exchangers further being provided with air guides (230, 330, 430, 530) arranged between adjacent heat exchangers for guiding the air through the heat exchangers, the heat exchangers being arranged to absorb heat from the air passing through the heat exchangers and expel the absorbed heat from the enclosure, **characterized in that** one or more of said air guides (330) are pivoted and held close by gravitational force and arranged to be displaced if a pressure within the enclosure exceeds a threshold value such that at least parts of the air entering the cooling unit can bypass the heat exchangers.

2. Cooling unit (110, 310, 410, 510, 610, 910, 1010a-c, 1110, 1210) for cooling air, the cooling unit being arranged for connection to an enclosure (100, 900, 1100, 1200) comprising heat generating equipment (235) so that air to be cooled can be induced into the cooling unit, the cooling unit comprising a plurality of heat exchangers (120) arranged in parallel to each other, the heat exchangers further being provided with air guides (230, 330, 430, 530) arranged between adjacent heat exchangers for guiding the air through the heat exchangers, the heat exchangers being arranged to absorb heat from the air passing through the heat exchangers and expel the absorbed heat from the enclosure, **characterized in that** one or more of said air guides (430) are arranged to be displaced by bending if a pressure within the enclosure exceeds a threshold value such that at least parts of the air entering the cooling unit can bypass the heat exchangers.

3. Cooling unit (110, 310, 410, 510, 610, 910, 1010a-c, 1110, 1210) for cooling air, the cooling unit being arranged for connection to an enclosure (100, 900, 1100, 1200) comprising heat generating equipment (235) so that air to be cooled can be induced into the cooling unit, the cooling unit comprising a plurality of heat exchangers (120) arranged in parallel to each other, the heat exchangers further being provided with air guides (230, 330, 430, 530) arranged between adjacent heat exchangers for guiding the air through the heat exchangers, the heat exchangers being arranged to absorb heat from the air passing through the heat exchangers and expel the absorbed heat from the enclosure, **characterized in that** one or more of said air guides (530) are arranged to be displaced by electro-mechanical actuation based upon output from one or more sensors for e.g. temperature, pressure, fan speed or a combination thereof positioned within the enclosure such that at least parts of the air entering the cooling unit can bypass the heat exchangers.

4. Cooling unit according to any of claims 1-3, wherein the cooling unit is configured to be connected to an air outlet (105b) or an air inlet (105a) of the enclosure, whereby the extension direction (201) of the heat exchangers is configured to substantially correspond to the direction of the air flow through said air outlet or air inlet with which the cooling unit is connected.

5. Cooling unit according to claims 3 or 4, whereby the cooling unit is in connection with one or more sensors (550) sensing said one or more conditions within the enclosure; and the cooling unit further comprising one or more controlling units (545) for changing the state of the air guides depending on said one or more conditions.

6. Cooling unit according to any of the preceding claims, wherein the cooling unit is 19 inches wide and 19 inches deep, so that it can be arranged on top or within a standard telecommunication cabinet.

7. Cooling unit according to any of the preceding claims, further comprising drop plates (655) arranged below the heat exchangers for collecting liquid from the heat exchangers.

8. Cooling unit according to any of the preceding claims, wherein the enclosure comprises an aisle containment (1165, 1265) and the cooling unit is arranged to be connected on top of the aisle containment.

9. Cooling unit according to claim 8, wherein the aisle containment is a cold aisle containment (1165) such that air is to be induced into the cooling unit (1110) from outside of the aisle containment.

10. Cooling unit according to claim 8, wherein the aisle containment is a hot aisle containment (1265) such that air is to be induced into the cooling unit (1110) from inside of the aisle containment.

11. An enclosure (100, 900,1000, 1100, 1200) comprising heat generating equipment (235), the enclosure further comprising:
one or more air inlets (105a, 1105a) for inducing air into the enclosure, the air absorbing heat from the heat generating equipment;
one or more air outlets (105b, 1105b) for expelling air from the enclosure;
**characterized in that**, the enclosure comprises a cooling unit according to any of claims 1-10.

12. An enclosure according to claim 11, wherein the heat exchangers are arranged on top of the enclosure or within the enclosure or on the back of the enclosure.

13. An enclosure according to any of the claims 11-12, wherein the heat exchangers are arranged in a substantially orthogonal manner in relation to the plane comprising the air outlet or air inlet with which the heat exchangers are connected.

## Patentansprüche

1. Kühleinheit (110, 310, 410, 510, 610, 910, 1010a-c, 1110, 1210) zum Kühlen von Luft, wobei die Kühleinheit zur Verbindung mit einem Gehäuse (100, 900, 1100, 1200) angeordnet ist, das ein Wärmeerzeugungsgerät (235) umfasst, sodass Luft, die zu kühlen ist, in die Kühleinheit geleitet werden kann, wobei die Kühleinheit mehrere Wärmetauscher (120) umfasst, die parallel zueinander angeordnet sind, wobei die Wärmetauscher ferner mit Luftführungen (230, 330, 430, 530) bereitgestellt sind, die zwischen benachbarten Wärmetauschern angeordnet sind, um die Luft durch die Wärmetauscher zu führen, wobei die Wärmetauscher angeordnet sind, um Wärme aus der Luft, die durch die Wärmetauscher strömt, zu absorbieren und die absorbierte Wärme aus dem Gehäuse abzugeben, **dadurch gekennzeichnet, dass** eine oder mehrere der Luftführungen (330) drehbar gelagert sind und durch Schwerkraft in einer Nähe gehalten werden und so angeordnet sind, dass sie verschoben werden, wenn ein Druck innerhalb des Gehäuses einen Schwellenwert übersteigt, sodass zumindest Teile der Luft, die in die Kühleinheit eintritt, die Wärmetauscher umgehen können.

2. Kühleinheit (110, 310, 410, 510, 610, 910, 1010a-c, 1110, 1210) zum Kühlen von Luft, wobei die Kühleinheit zur Verbindung mit einem Gehäuse (100, 900, 1100, 1200) angeordnet ist, das ein Wärmeerzeugungsgerät (235) umfasst, sodass Luft, die zu kühlen ist, in die Kühleinheit geleitet werden kann, wobei die Kühleinheit mehrere Wärmetauscher (120) umfasst, die parallel zueinander angeordnet sind, wobei die Wärmetauscher ferner mit Luftführungen (230, 330, 430, 530) bereitgestellt sind, die zwischen benachbarten Wärmetauschern angeordnet sind, um die Luft durch die Wärmetauscher zu führen, wobei die Wärmetauscher angeordnet sind, um Wärme aus der Luft, die durch die Wärmetauscher strömt, zu absorbieren und die absorbierte Wärme aus dem Gehäuse abzugeben, **dadurch gekennzeichnet, dass** eine oder mehrere der Luftführungen (430) zum Verschieben durch Biegen angeordnet sind, wenn ein Druck innerhalb des Gehäuses einen Schwellenwert übersteigt, sodass zumindest Teile der Luft, die in die Kühleinheit eintritt, die Wärmetauscher umgehen können.

3. Kühleinheit (110, 310, 410, 510, 610, 910, 1010a-c, 1110, 1210) zum Kühlen von Luft, wobei die Kühleinheit zur Verbindung mit einem Gehäuse (100, 900, 1100, 1200) angeordnet ist, das ein Wärmeerzeugungsgerät (235) umfasst, sodass Luft, die zu kühlen ist, in die Kühleinheit geleitet werden kann, wobei die Kühleinheit mehrere Wärmetauscher (120) umfasst, die parallel zueinander angeordnet sind, wobei die Wärmetauscher ferner mit Luftführungen (230, 330, 430, 530) bereitgestellt sind, die zwischen benachbarten Wärmetauschern angeordnet sind, um die Luft durch die Wärmetauscher zu führen, wobei die Wärmetauscher angeordnet sind, um Wärme aus der Luft, die durch die Wärmetauscher strömt, zu absorbieren und die absorbierte Wärme aus dem Gehäuse abzugeben, **dadurch gekennzeichnet, dass** eine oder mehrere der Luftführungen (530) zur Verschiebung durch elektro-mechanische Betätigung angeordnet sind, basierend auf einem Ausgang von einem oder mehreren Sensor(en) für z.B. Temperatur, Druck. Gebläsegeschwindigkeit oder eine Kombination davon, die in dem Gehäuse positioniert sind, sodass zumindest Teile der Luft, die in die Kühleinheit eintritt, die Wärmetauscher umgehen können.

4. Kühleinheit nach einem der Ansprüche 1-3, wobei die Kühleinheit gestaltet ist, mit einem Luftauslass (105b) oder einem Lufteinlass (105a) des Gehäuses verbunden zu sein, wobei die Ausdehnungsrichtung (201) der Wärmetauscher so gestaltet ist, dass sie im Wesentlichen der Richtung des Luftstroms durch den Luftauslass oder Lufteinlass entspricht, mit dem die Kühleinheit verbunden ist.

5. Kühleinheit nach Ansprüchen 3 oder 4, wobei die Kühleinheit in Verbindung mit einem oder mehreren Sensor(en) (550) ist, die eine oder mehrere Bedingung(en) innerhalb des Gehäuses erfassen; und die Kühleinheit ferner eine oder mehrere Steuereinheit(en) (545) zum Ändern des Zustands der Luftführungen abhängig von der einen oder den mehreren Bedingung(en) umfasst.

6. Kühleinheit nach einem der vorangehenden Ansprüche, wobei die Kühleinheit 19 Inch breit und 19 Inch tief ist, sodass sie auf oder in einem Standardtelekommunikationsschrank montiert werden kann.

7. Kühleinheit nach einem der vorangehenden Ansprüche, ferner umfassend Ablaufbleche (655), die unter den Wärmetauschern zum Sammeln von Flüssigkeit aus den Wärmetauschern angeordnet sind.

8. Kühleinheit nach einem der vorangehenden Ansprüche, wobei das Gehäuse eine Gangeinhausung (1165, 1265) umfasst und die Kühleinheit so angeordnet ist, dass sie an der Oberseite der Gangeinhausung verbunden ist.

9. Kühleinheit nach Anspruch 8, wobei die Gangeinhausung eine Kaltgangeinhausung (1165) ist, sodass Luft von der Außenseite der Gangeinhausung in die Kühleinheit (1110) geleitet wird.

10. Kühleinheit nach Anspruch 8, wobei die Gangeinhausung eine Warmgangeinhausung (1265) ist, sodass Luft von der Innenseite der Gangeinhausung in die Kühleinheit (1110) geleitet wird.

11. Gehäuse (100, 900, 1100, 1200), umfassend das Wärmeerzeugungsgerät (235), wobei das Gehäuse ferner umfasst:
- einen Lufteinlass oder mehrere Lufteinlässe (105a, 1105a) zum Einleiten von Luft in das Gehäuse, wobei die Luft Wärme aus dem Wärmeerzeugungsgerät absorbiert;
- einen Luftauslass oder mehrere Luftauslässe (105b, 1105b) zum Abgeben von Luft aus dem Gehäuse;
**dadurch gekennzeichnet, dass** das Gehäuse eine Kühleinheit nach einem der Ansprüche 1-10 umfasst.

12. Gehäuse nach Anspruch 11, wobei die Wärmetauscher auf dem Gehäuse oder in dem Gehäuse oder an der Rückseite des Gehäuses angeordnet sind.

13. Gehäuse nach einem der Ansprüche 11-12, wobei die Wärmetauscher im Wesentlichen orthogonal in Bezug auf die Ebene angeordnet sind, die den Luftauslass oder Lufteinlass umfasst, mit dem die Wärmetauscher verbunden sind.

## Revendications

1. Unité de refroidissement (110, 310, 410, 510, 610, 910, 1010a-c, 1110, 1210) pour refroidir de l'air, l'unité de refroidissement étant aménagée pour être raccordée à une enceinte (100, 900, 1100, 1200) comprenant un équipement générateur de chaleur (235) de sorte que de l'air à refroidir puisse être induit dans l'unité de refroidissement, l'unité de refroidissement comprenant une pluralité d'échangeurs de chaleur (120) agencés en parallèle l'un avec l'autre, les échangeurs de chaleur étant en outre pourvus de guides d'air (230, 330, 430, 530) agencés entre des échangeurs de chaleur adjacents pour guider l'air à travers les échangeurs de chaleur, les échangeurs de chaleur étant agencés pour absorber la chaleur de l'air passant à travers les échangeurs de chaleur et expulser la chaleur absorbée de l'enceinte, **caractérisée en ce que** les un ou plusieurs dits guides d'air (330) sont articulés et maintenus proches par la force de la pesanteur et agencés pour être déplacés si une pression dans l'enceinte dépasse une valeur de seuil de sorte qu'au moins des parties de l'air pénétrant dans l'unité de refroidissement puissent contourner les échangeurs de chaleur.

2. Unité de refroidissement (110, 310, 410, 510, 610, 910, 1010a-c, 1110, 1210) pour refroidir de l'air, l'unité de refroidissement étant agencée pour se raccorder à une enceinte (100, 900, 1100, 1200) comprenant un équipement générateur de chaleur (235) de sorte que de l'air à refroidir puisse être induit dans l'unité de refroidissement, l'unité de refroidissement comprenant une pluralité d'échangeurs de chaleur (120) agencés en parallèle l'un avec l'autre, les échangeurs de chaleur étant en outre pourvus de guides d'air (230, 330, 430, 530) agencés entre des échangeurs de chaleur adjacents pour guider l'air à travers les échangeurs de chaleur, les échangeurs de chaleur étant agencés pour absorber la chaleur provenant de l'air passant à travers les échangeurs de chaleur et expulser la chaleur absorbée de l'enceinte, **caractérisée en ce qu'**un ou plusieurs desdits guides d'air (430) est ou sont agencés pour être déplacés par flexion si une pression au sein de l'enceinte dépasse une valeur de seuil de sorte qu'au moins des parties de l'air entrant dans l'unité de refroidissement puissent contourner les échangeurs de chaleur.

3. Unité de refroidissement (110, 310, 410, 510, 610, 910, 1010a-c, 1110, 1210) pour refroidir de l'air, l'unité de refroidissement étant agencée pour se raccorder à une enceinte (100, 900, 1100, 1200) comprenant un équipement générateur de chaleur (235) de sorte que de l'air à refroidir puisse être induit dans l'unité de refroidissement, l'unité de refroidissement comprenant une pluralité d'échangeurs de chaleur (120) agencés en parallèle l'un avec l'autre, les échangeurs de chaleur étant en outre pourvus de guides d'air (230, 330, 430, 530) agencés entre des échangeurs de chaleur adjacents pour guider l'air à travers les échangeurs de chaleur, les échangeurs de chaleur étant agencés pour absorber la chaleur provenant de l'air passant à travers les échangeurs de chaleur et expulser la chaleur absorbée de l'enceinte, **caractérisée en ce qu'**un ou plusieurs desdits guides d'air (530) est ou sont agencés pour être déplacés par actionnement électromécanique sur la base de la sortie d'un ou plusieurs capteurs pour, par exemple, la température, la pression, la vitesse d'un ventilateur ou une de leurs combinaisons, positionnés dans l'enceinte de sorte qu'au moins des parties de l'air entrant dans l'unité de refroidissement puissent contourner les échangeurs de chaleur.

4. Unité de refroidissement selon l'une quelconque des revendications 1 à 3, dans laquelle l'unité de refroidissement est configurée pour être raccordée à une sortie d'air (105b) ou à une entrée d'air (105a) de l'enceinte, de sorte que la direction d'extension (201) des échangeurs de chaleur soit configurée pour correspondre sensiblement à la direction de l'écoulement d'air à travers ladite sortie d'air ou ladite entrée d'air avec laquelle l'unité de refroidissement est raccordée.

5. Unité de refroidissement selon les revendications 3 ou 4, dans laquelle l'unité de refroidissement est en liaison avec un ou plusieurs capteurs (550) détectant un ou plusieurs états au sein de l'enceinte ; et l'unité de refroidissement comprend en outre une ou plusieurs unités de commande (545) pour changer l'état des guides d'air en fonction desdits un ou plusieurs états.

6. Unité de refroidissement selon l'une quelconque des revendications précédentes, dans laquelle l'unité de refroidissement a une largeur de 19 pouces et une profondeur de 19 pouces de sorte qu'elle puisse être aménagée au-dessus ou à l'intérieur d'une armoire de télécommunication standard.

7. Unité de refroidissement selon l'une quelconque des revendications précédentes, comprenant en outre des plaques à gouttes (655) agencées en dessous des échangeurs de chaleur pour recueillir le liquide provenant des échangeurs de chaleur.

8. Unité de refroidissement selon l'une quelconque des revendications précédentes, dans laquelle l'enceinte comprend un confinement de passage (1165, 1265) et l'unité de refroidissement est aménagée pour être raccordée par-dessus le confinement de passage.

9. Unité de refroidissement selon la revendication 8, dans laquelle le confinement de passage est un confinement de passage froid (1165) de sorte que de l'air doive être induit dans l'unité de refroidissement (1110) de l'extérieur du confinement de passage.

10. Unité de refroidissement selon la revendication 8, dans laquelle le confinement de passage est un confinement de passage chaud (1265) tel que de l'air doive être induit dans l'unité de refroidissement (1110) de l'intérieur du confinement de passage.

11. Enceinte (100, 900, 1000, 1100, 1200) comprenant un équipement générateur de chaleur (235), l'enceinte comprenant en outre :
une ou plusieurs entrées d'air (105a, 1105a) pour induire de l'air dans l'enceinte, l'air absorbant la chaleur provenant de l'équipement générateur de chaleur ;
une ou plusieurs sorties d'air (105b, 1105b) pour expulser l'air de l'enceinte ;
**caractérisée en ce que** l'enceinte comprend une unité de refroidissement selon l'une quelconque des revendications 1 à 10.

12. Enceinte selon la revendication 11, dans laquelle les échangeurs de chaleur sont aménagés par-dessus l'enceinte ou dans l'enceinte ou au dos de l'enceinte.

13. Enceinte selon l'une quelconque des revendications 11 à 12, dans laquelle les échangeurs de chaleur sont agencés de manière sensiblement orthogonale par rapport au plan comprenant la sortie d'air ou l'entrée d'air avec laquelle les échangeurs de chaleur sont raccordés.
